**Europäisches Patentamt**

**European Patent Office**

**Office européen des brevets**

(19)

(11) Veröffentlichungsnummer: **0 000 327**
**B1**

(12) **EUROPÄISCHE PATENTSCHRIFT**

(45) Veröffentlichungstag der Patentschrift: **13.01.82**

(51) Int. Cl.³: **H 01 L 21/00**

(21) Anmeldenummer: **78100092.2**

(22) Anmeldetag: **06.06.78**

(54) **Verfahren zum Herstellen von integrierten Halbleiteranordnungen durch Anwendung einer auf Selbstausrichtung basierenden Maskierungstechnik.**

(30) Priorität: **12.07.77 US 814801**

(43) Veröffentlichungstag der Anmeldung:
**24.01.79 Patentblatt 79/2**

(45) Bekanntmachung des Hinweises auf die Patenterteilung:
**13.01.82 Patentblatt 82/2**

(84) Benannte Vertragsstaaten:
**DE FR GB**

(56) Entgegenhaltungen:
**FR - A - 2 160 067**
**FR - A - 2 192 382**
**FR - A - 2 280 201**
**FR - A - 2 358 748**
**US - A - 3 771 218**

(73) Patentinhaber: **International Business Machines Corporation**
**Armonk, N.Y. 10504 (US)**

(72) Erfinder: **Chang, Augustine Wei-Chun,**
**19 Hill Top Drive**
**Wappingers Falls New York, 12590 (US)**
Erfinder: **Gaind, Arun Kumar**
**South Terrace**
**Fishkill New York, 12524 (US)**

(74) Vertreter: **Gaugel, Heinz, Dipl.-Ing.**
**Schönaicher Strasse 220**
**D-7030 Böblingen (DE)**

Courier Press, Leamington Spa, England.

## 0 000 327

### Verfahren zum Herstellen von integrierten Halbleiteranordnungen durch Anwendung einer auf Selbstausrichtung basierenden Maskierungstechnik

Die Erfindung bezieht sich auf ein Verfahren zum Herstellen von integrierten Halbleiteranordnungen gemäß dem ersten Teil des Anspruchs

Ein grundsätzlicher, kritischer Faktor bei der Auslegung von integrierten Halbleiteranordnungen, die auf einem Halbleiterchip unterzubringen sind, ist die Verlustleistung. Durch die auftretende Verlustleistung wird die Zahl der Bauelemente oder Schaltungen die auf einem Halbleiterchip gegebener Größe unterzubringen ist, und die Operationsgeschwindigkeit der Schaltungen begrenzt. Ganz allgemein kann man feststellen, daß die auftretende Verlustleistung mit der Geschwindigkeit der Schaltungen ansteigt. Außerdem ist die auftretende Verlustleistung eine direkte Funktion der Anzahl der auf einem Halbleiterchip angeordneten Bauelemente bzw. Schaltungen.

Eine längst bekannte Lösung des sich aus diesem Sachverhalt ergebenden Problems besteht in der Verminderung der Größe, insbesondere der flächenmäßigen Ausdehnung der einzelnen Elemente. Dadurch lassen sich auf einem Halbleiterchip bestimmter Größe mehr Bauelemente integrieren und die auftretenden parasitären Kapazitäten vermindern. Der Betrieb erfolgt bei höheren Impedanzwerten für eine vorgegebene Operationsgeschwindigkeit, was zu einer Erniedrigung der Verlustleistung führt. Das Problem der Verlustleistung ist besonders bei in Planartechnik hergestellten, vertikalen Bipolartransistoren von Bedeutung. Dieses Problem ist aber auch bei der Verwirklichung von lateralen Bipolartransistoren und bei Feldeffekttransistoren nicht zu vernachlässigen.

Insbesondere bei vertikalen Bipolartransistoren sind die Basiszone, die Kollektor-Kontaktierungszone und die erforderlichen Isolationszonen genau aufeinander auszurichten, wenn geringe Abmessungen des Bauelementes erzielt werden sollen. Diese Ausrichtung erweist sich als außerordentlich schwierig, da diese einzelnen Zonen in getrennten Prozeßschritten herzustellen sind. Die Definition jeder dieser Zonen erfordert einen separaten Maskierungsprozeß, an den jeweils anschließend durch Diffusion, Ionenimplantation, dielektrische Isolation oder durch Kombinationen dieser Prozesse die entsprechende Zone gebildet werden. Der konventionelle Maskierungsprozeß umfaßt die Beschichtung der Oberfläche des Halbleiterkörpers mit einer dielektrischen Schicht, auf der sich wiederum eine Photolackschicht befindet. Die Photolackschicht wird mit Hilfe einer Belichtungsmaske geeignet belichtet und entwickelt, so daß ein Maskenmuster entsprechend dem zu erzeugenden Zonenmuster entsteht. Mit Hilfe dieser Maske als Ätzmaske wird ein entsprechendes Muster in die dielektrische Schicht geätzt. Abschließend erfolgt das Einbringen der zu bildenden Zonen.

Durch die notwendigerweise vorzusehenden Ausrichtungstoleranzen der einzelnen aufeinanderfolgenden Masken ist es bedingt, daß die Ausdehnungen der Zonen selbst und ihre gegenseitigen Abstände bestimmte Mindestmaße nicht unterschreiten können.

Jede Maske muß exakt in bezug auf das Muster einer vorhergehenden Maske ausgerichtet werden. Da eine vollkommene Ausrichtung nicht erzielbar ist, müssen bestimmte Toleranzen zugelassen werden. Das bedeutet aber, daß Zonen bzw. Bauelemente entstehen, deren Abmessungen und gegenseitige Abstände größer sind als es die angestrebten Schaltungsparameter erfordern würden.

Entsprechende Probleme treten ebenso bei komplexen Schaltungen mit lateralen Bipolartransistoren, komplementären Feldeffekttransistoren und anderen Bauelementen auf.

Es ist bereits bekannt geworden, daß das Erfordernis einer vollkommenen Maskenausrichtung in jedem Maskierungsprozeß durch Anwendung einer auf Selbstausrichtung basierenden Maskierungstechnik zu umgehen. Entsprechende Techniken sind in den US—Patentschriften 3 928 082, 3 948 694, 3 967 981 und 3 900 352 beschrieben.

Ein Verfahren gemäß dem ersten Teil des Anspruchs 1 ist aus der US—A 3 771 218 bekannt.

Aus der FR—A 2 192 382 ist es bekannt, daß ein einer ersten Teilmenge entsprechendes Zonenmuster Isolationszonen und das einer zweiten und dritten Teilmenge entsprechende Zonenmuster dotierte Halbleiterzonen umfaßt.

Die Anwendung dieser bekannten Verfahren offenbart gewisse Beschränkungen, derart, daß die Herstellung einer oder mehrerer Halbleiterzonen die Anwendung der maskierten Ionenimplantation erforderlich macht, oder daß die Anzahl der selbstausrichtend herstellbaren Halbleiterzonen begrenzt ist. Beispielsweise ist es nicht möglich, eine dielektrische Isolationszone selbstausrichtend in bezug auf Basis- und Kollektor-Kontaktzonen eines Bipolartransistors oder in bezug auf Sourcezone, Drainzone und Substraktkontakt eines Feldeffekttransistors herzustellen.

Die bekannten Verfahren lösen auch nicht vollkommen das Problem, das als Unterätzen einer Maskierungsschicht bekannt ist, die während eines Ätzprozesses unterhalb einer anderen Maskierungsschicht angeordnet ist. Der unterätzte Bereich vergrößert die effektive Fläche des Maskenfensters und kann zu Überlappungen von Zonen führen, die einen Abstand voneinander aufweisen müssen.

Hier will die Erfindung Abhilfe schaffen. Die Erfindung, wie sie in den Ansprüchen gekennzeichnet ist, löst die Aufgabe, ein selbstausrichtendes Maskierungsverfahren anzugeben, durch das die Herstellung von integrierten Halbleiteranordnungen erhöhter Dichte ermöglicht und gleichzeitig das Problem der Unterätzung von Maskierungsschichten vermieden wird.

Die durch Erfindung erreichten Vorteile sind im wesentlichen darin zu sehen, daß durch Anwendung konventioneller photolithographischer Prozesse in Verbindung mit Sperrmasken, die keine kritische Ausrichtung erforderlich machen, mehr als zwei unterschiedliche Zonen in einem Halbleiterkörper selbstausrichtend herstellbar sind.

Die Erfindung wird im folgenden anhand der Zeichnung mäher erläutert.

Es zeigen:

Fign. 1A Schnittansichten einer Struktur mit einem bis 1I Bipolartransistor in aufeinanderfolgenden Stufen der erfindungsgemäßen Herstellungsverfahrens,

Fig. 2 eine Draufsicht der Transistorstruktur in der Verfahrensstufe gemäß Fig. 1I und

Fign. 3A Schnittansichten eines CMOSFET—Struktur in auf bis 3E einanderfolgenden Stufen des erfindungsgemäßen Herstellungsverfahren.

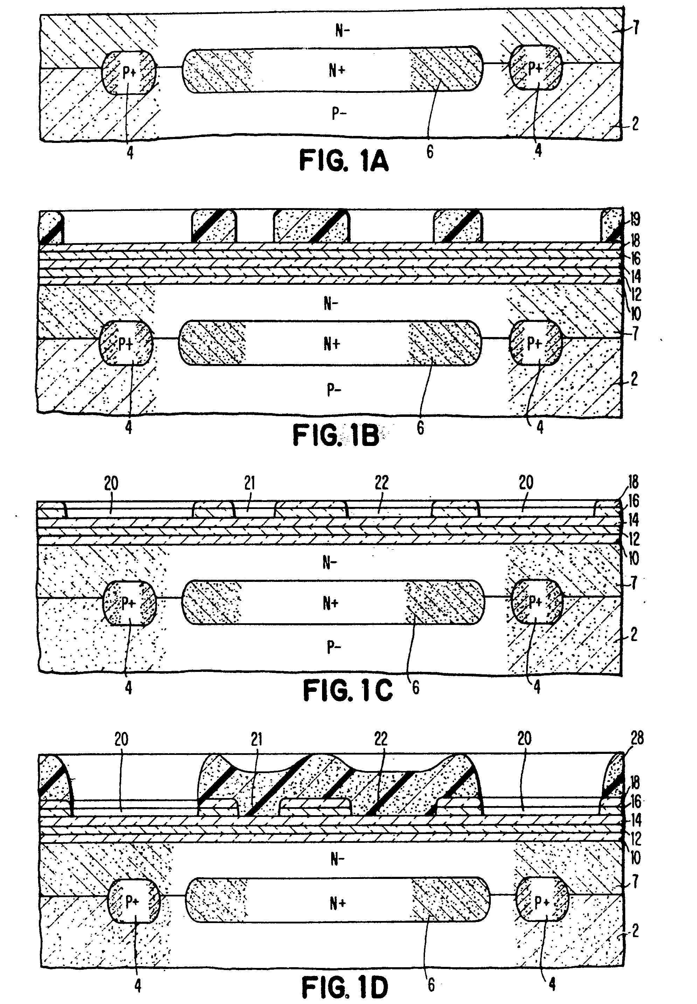

Wie in Fig. 1A gezeigt, wird ein P-dotiertes Substrat aus Silicium verwendet, um einen von weiteren, nicht dargestellten Elementen auf demselben Halbleiterchip durch dielektrische Isolation isolierten NPN—Transistor herzustellen. Selbstverständlich eignet sich das erfindungsgemäße Verfahren auch zur Herstellung von Bipolartransistoren entgegengesetzten Leitfähigkeitstyps und anderen Halbleiterbauelementen wie beispielsweise Feldeffekt-Transistoren.

Auf das $P^-$-dotierte Substrat 2 ein eine $N^-$-dotierte Epitaxieschicht 7 aufgebracht. Entsprechend der üblichen Technik ist ein $N^+$-dotierter Subkollektor 6 und eine $P^+$-dotierte Sperrschicht-Isolationszone 4 vorgesehen. Diese standardmäßigen vergrabenen Zonen stehen in keinem unmittelbaren Zusammenhang mit der erfindungsgemäßen Verfahren.

Aus Fig. 1B ist zu ersehen, daß drei unterschiedliche Maskierungsschichten auf die Epitaxieschicht 7 aufgebracht sind. Mit Hilfe dieser Maskierungsschichten werden die im betrachteten Beispiel herzustellenden Zonen in die Epitaxieschicht eingebracht. Im betrachteten Beispiel sind in Wirklichkeit fünf getrennte Schichten auf der Epitaxieschicht vorhanden, nämlich eine erste Zusatzschicht 10, eine erste, zweite und dritte Maskierungsschicht 16, 14, 12 und eine zweite Zusatzschicht 18. Wie im folgenden noch beschrieben wird, bilden jedoch die erste Zusatzschicht 10 und die dritte Maskierungsschicht 12 eine zusammengesetzte Maskierungsschicht und die zweite Zusatzschicht 18 ist im Rahmen des erfindungsgemäßen Verfahrens nicht unbedingt erforderlich, jedoch vorteilhaft.

Auf die Oberfläche der zweiten Zusatzschicht 18 ist eine Bemessungsmaske 19 aufgebracht, die ein die Gesamtmenge der in der Epitaxieschicht 7 zu bildenden Zonen definierendes Muster enthält. Die Bemessungsmaske 19 besteht vorzugsweise aus einem Photolack, der in konventioneller Weise belichtet und entwickelt wird.

Beim hier beispielweise betrachteten, bevorzugten Ausführungsbeispiel sind die Maskierungsschichten zusammengesetzt aus einer ersten Zusatzschicht 10 aus Siliciumdioxid, einer dritten Maskierungsschicht 12 aus Siliciumoxynitrid, einer zweiten Maskierungsschicht 14 aus Siliciumdioxid, einer ersten Maskierungsschicht 16 aus Siliciumnitrid und eine zweiten Zusatzschicht 18 aus Siliciumdioxid. Jede dieser Schichten ist mittels bekannter Verfahren aufgebracht, die selbst nicht Teil der Erfindung sind.

Die erste Zusatzschicht 10 aus Siliciumdioxid wird in vorteilhafter Weise thermisch in einer Dicke von 25 bis 100 nm aus der Epitaxieschicht 7 aufgewachsen. Das Aufbringen der dritten Maskierungsschicht 12 aus Siliciumoxynitrid erfolgt vorzugsweise durch ein chemisches Aufdampfverfahren, wie es beispielsweise in "J. Electrochemical Society", Vol. 124, Nr. 4, April 1977, auf den Seiten 599 bis 606 von Gaind et al unter dem Titel "Oxynitride Deposition Kinetics in a $SiH—CO_2—NH_3—H_2$ System" beschrieben ist. Die Dicke der dritten Maskierungsschicht 12 liegt in der Größenordnung von 50 bis 100 nm.

Auch die Schichten 14 und 18 aus Siliciumdioxid werden vorzugsweise in einem chemischen Ausdampfprozeß aufgebracht und weisen eine Dicke von etwa 50 und 100 bis 200 nm auf. Die erste Maskierungsschicht 16 aus Siliciumnitrid wird vorzugsweise ebenfalls in einem chemischen Aufdampfprozeß in einer Dicke von 50 bis 100 nm aufgebracht.

Im Rahmen der Herstellung von Bipolartransistoren wählt man vorzugsweise für die Schichten 10, 14 und 18 Dicken von 25, 50 und 100 nm. Um das Unterätzen einer oberen Schicht zu verhindern, wenn die untere Schicht im Bereich eines Maskenfensters in der oberen Schicht geätzt wird, wählt man im allgemeinen die Dicken der Schichten im Verhältnis von 1:2:4.

Selbstverständlich ist das erfindungsgemäße Verfahren nicht auf die angebenen Materialien und Beschichtungstechniken begrenzt. Für das erfindungsgemäße Verfahren ist ausschlaggebend, daß drei Maskierungsschichten verwendet werden, die unabhängig voneinander ätzbar sind. Damit ist gemeint, daß ein bestimmtes Ätzmittel, das das Material der einen Schicht angreift, nicht oder nur mit einer geringeren Ätzrate die Materialien der beiden anderen Schichten angreift.

Beim beispiels weise betrachteten Ausführungsbeispiel werden als Materialien für die drei unabhängig voneinander ätzbaren Maskierungsschichten 12, 14 und 16 Siliciumoxynitrid, Siliciumdioxid' und Siliciumnitrid gewählt. Beispielsweise greift heiße Phosphorsäure Siliciumnitrid aber kaum Siliciumdioxid an. Diese Säure ätzt auch Siliciumoxynitrid ungefähr 2, 5 mal schneller als Siliciumnitrid. Gepufferte Fluorwasserstoffsäure ätzt Siliciumdioxid, greift aber kaum Siliciumnitrid oder Siliciumoxynitrid an.

Die verschiedenen Ätzchritte können auch in Form von Plasmaätzen durchgeführt werden. Durch Plasmaätzen wird Siliciumoxynitrid zwei bis dreimal schneller geätzt als Siliciumnitrid. Chemisch aufgedampftes Siliciumdioxid wird bis sechts bis zehnmal langsamer geätzt als Siliciumnitrid. Bei anisotropem Plasmaätzen kann die Siliciumoxynitridschicht 12 durch eine Schicht aus Siliciumnitrid ersetzt werden. In diesem Fall sollte die Schicht 16 aus Siliciumnitrid mindestens doppelt so dick wie die siliciumoxynitridschicht 12 sein.

Es sind auch andere Materialien für die Maskierungsschichten einsetzbar. Beispielsweise kann Chrom oder Aluminium anstelle von Siliciumnitrid und Molybdän anstelle von Siliciumoxynitrid verwendet werden. Wird eine dielektrische Oxidationstechnik in Form von eingelassenen Isolationszonen verwendet, so kann Siliciumnitrid oder Siliciumoxynitrid durch polykristallines Silicium ersetzt werden, das mit Pyrokatechol selektiv ätzbar ist.

Im Verfahrensschritt gemäß Fig. 1C werden Fenster 20, 21 und 22 unter Verwendung der Bemessungsmaske 19 in die freiliegenden Bereiche der ersten Maskierungsschicht 16 und der zweiten Zusatzschicht 18 geätzt. Dabei wird zunächst die aus Siliciumdoxid bestehende zweite Zusatzchicht 18 mit gepufferter Flußsäure geätzt, die zwar Siliciumdoxid angreift, aber in bezug auf Siliciumnitrid oder Photolack wirkungslos bleibt. Nach dem Freilegen der Fenster in der zweiten Zusatzschicht 18 wird diese Schicht als Maske zum Ätzen der entsprechenden Öffnungen 20, 21 und 22 in der ersten Maskierungsschicht 16 aus Siliciumnitrid verwendet. Die einzige Aufgabe der zweiten Zusatzschicht 18 besteht also in der Maskierung der ersten Maskierungsschicht 16, da Atzmittel, wie beispielsweise heiße Phosphorsäure, neben Siliciumnitrid auch konventionelle Photolacke angreifen. Anstelle chemisch aufgedampfter zweiter Zusatzsschichten 18 sind auch solche verwendbar, die Sputtern aufgebracht werden. Die zweite Zusatzschicht 18 kann auch völlig entfallen, wenn der normale Ätzprozeß durch Plasmaätzen ersetzt wird. Das Plasmätzen, auch reaktives Ionenätzen genannt, ist dem Fachmann hinreichend geläufig. Geeignete Mittel zum Ätzen von beispielsweise Siliciumnitrid sind im Handel erhältlich Beim betrachteten Ausführungsbeispiel soll der Bereich des Substrats 7 unterhalb des Fensters 20 in eine dielektrische Isolationszone umgewandelt werden. Der Bereich unterhalb des Fensters 21 soll als Kontaktierungszone zum Subkollektor 6 ausgebildet werden. Der Bereich unterhalb des Fensters 22 wird als Basiszone des Bipolartransistors ausgebildet. Diese genannten drei Zonen sind erfindungsgemäß automatisch aufeinander ausgerichtet.

Eine Sperrmaske 28 deckt, wie in Fig. 1D dargestellt, die Bereiche der Fenster 21 und 22 ab, jedoch nicht den Bereich des Fensters 20. Die Öffnungen in der Sperrmaske 28 für das Fenster 20 erfordern keinen kritischen Ausrichtprozeß, da die erste Maskierungsschicht 16 aus Siliciumnitrid eine Ausweitung des Fensters 20 in lateraler Richtung verhindert. Das heißt also, die Ränder der Öffnungen in der Sperrmaske 28 aus Photolack müssen nicht exakt auf die Ränder der Schichten 16 und 18 im Bereich der Fenster 20 ausgerichtet sein.

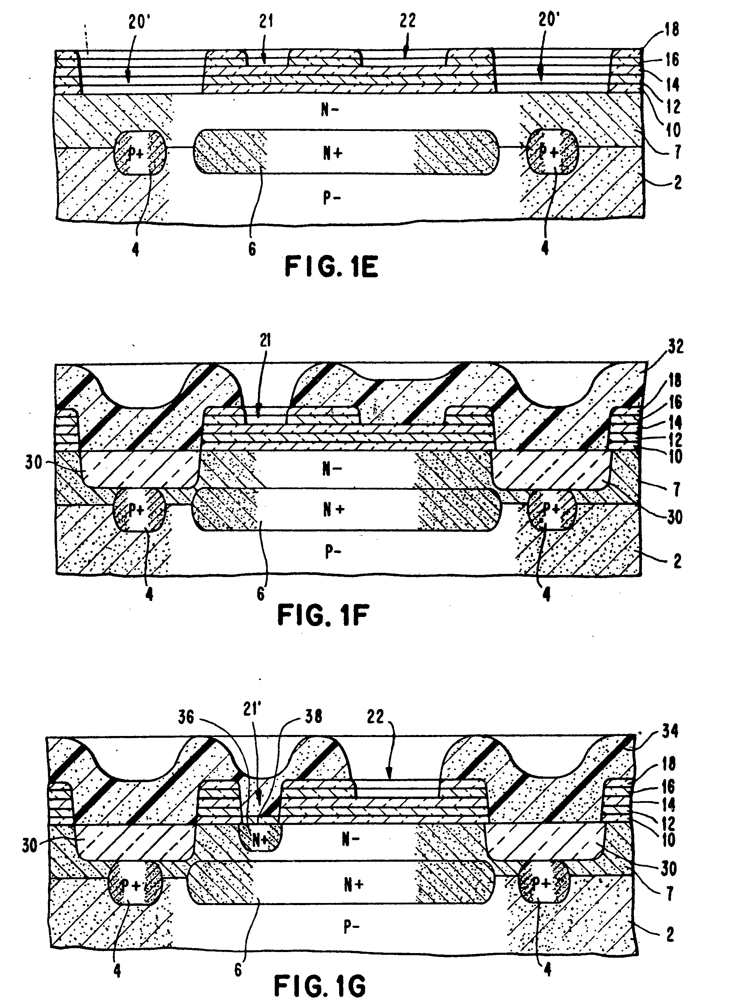

Wie in Fig. 1E dargestellt, wird nun das Fenster 20' bis zur Epitaxieschicht 7 geöffnet. Dabei wird die zweite Maskierungsschicht 14 aus Siliciumdioxid mit gepufferter Flußsäure geätzt, wobei gleichzeitig die Sperrmaske 28 entfernt wird. Das Ätzen der dritten Maskierungsschicht 12 aus Siliciumoxynitrid erfolgt mit heißer Phosphorsäure. Schließlich wird die erste Zusatzschicht 10 aus Siliciumdioxid mit gepufferter Flußsäure abgeätzt.

Beim Ätzen der dritten Maskierungsschicht 12 aus Siliciumoxynitrid dient die zweite Maskierungsschicht 14 aus Siliciumdioxid als Maske. Beim Ätzen der ersten Zusatzschicht 10 aus Siliciumdioxid wirkt die dritte Maskierungsschicht 12 aus Siliciumoxynitrid als Maske. Die erste Zusatzschicht 10 aus Silicumdioxid dient als Zwischenschicht zwischen der dritten Maskierungsschicht 12 aus Siliciumoxynitrid und dem Substrat aus reinem Silicium. Siliciumoxynitrid hat die Eigenschaft, höhere Störstellendichten als Siliciumdioxid zu erzeugen. Dies ist jedoch im Hinblick auf die Brauchbarkeit des erfindungemäßen Verfahrens unkritisch. Bei der Bildung der Isolationszonen aus Siliciumdioxid entstehen im Silicium in der Nähe der Schicht aus Siliciumoxynitrid Versetzungen, die die Ausbeute vermindern können. Um das zu vermeiden, wird die erste Zusatzschicht aus Siliciumdioxid oder aus einem anderen Dielektrikum in einer Dicke von mindestens 25 nm aufgebracht, durch die im Silicium unterhalb der Schicht aus Siliciumoxynitrid eine mechanische Spannung erzeugt wird. Nach der Freilegung des Fensters 20' wird nun die dielektrische Isolationszone 30 gebildet, was in Fig. 1F dargestellt wird. Diese Isolationszone 30 besteht vorzugsweise aus Siliciumdioxid, das thermisch aus der Siliciumschicht, 7 gewachsen werden kann. Dabei handelt es sich um ein gängiges Verfahren. Vorzugsweise wird diese Isolationszone 30 dadurch erzeugt, daß zunächst durch Plasmätzen in Bereich des Fensters 20' ein Teil des Siliciums entfernt. Die dabei entstehende Vertiefung wird anschließend während eines Oxidationsprozesses mit Siliciumdioxid aufgefüllt.

Anstelle der dielektrischen Isolation kann, auch eine Sperrschichtisolation vorgesehen werden. In diesem Falle wird anstelle der dielektrischen Isolationszone 30 eine im betrachteten Ausführungsbeispiel $P^+$-dotierte Isolationszone vorgesehen. Diese kann durch Diffusion oder Ionenimplantation hergestellt werden.

An dieser Stelle ist darauf hinzuweisen, daß die in der vorstehend beschriebenen Verfahrensstufe hergestellte Zone auch eine andere Funktion als die Funktion der Isolation haben kann. Beispielweise kann es sich um eine Zone handeln, die einen Widerstand, eine Schottky-Diode oder irgendeine andere Halbleiterzone bildet.

Es ist außerdem in allen Fällen erforderlich, die Fenster bis zur Oberfläche des Siliciumsubstrats zu öffnen. Beispielsweise ist es bei Ionenimplantationsprozessen vorteilhaft, die Implantation durch eine

dünne Isolationsschicht hindurch vorzunehmen. Man kann also entweder die Schichten 10 oder 12 oder auch beide Schichten im Bereich der Fenster belassen und durch sie hindurch eine Implantation von Ionen in die Epitaxieschicht 7 vornehmen. Das für das erfindungsgemäße Verfahren wesentliche Merkmal steht darin, die Zone mit Rücksicht auf die in nachfolgenden Verfahrensschritten herzustellenden weiteren Zonen selbstausrichtend herzustellen.

Nach der Bildung der Isolationszone 30 wird eine zweite Sperrmaske 32 aus Photolack aufgebracht, geeignet belichtet und entwickelt, so daß lediglich das Fenster 21 unbedeckt bleibt. Die entsprechende Struktur ist in Fig. 1F dargestellt. Bei der zweiten Sperrmaske 32 handelt es sich also wiederum, wie im Falle der ersten Sperrmaske 28, um konventionelles Photolackmaterial, durch das sämtliche Bereiche geschützt werden mit Ausnahme der, in denen Fenster zur Epitaxieschicht 7 freigelegt werden sollen.

Im nächsten Verfahrensschritt (Fig. 1G) wird ein Fenster 21' im Bereich des Fensters 21 bis zur Epitaxieschicht 7 geöffnet. Der angewandte Prozeß entspricht dem bereits im Zusammenhang mit Fenster 20' beschriebenen Ätzprozeß. Während des Abätzens des freiliegenden Bereiches der zweiten Maskierungsschicht 14 aus Siliciumdioxid oder auch nach dem Ätzen wird die zweite Sperrmaske vollkommen entfernt. Durch das Fenster 21' wird eine $N^+$-dotierte Kontaktzone 36 in die Epitaxieschicht 7 eingebracht, diese Zone kann entweder als Verbindungszone zum Subkollektor oder als Kontaktzone zur Epitaxieschicht 7 verwendet werden. Die Zone wird durch Diffusion oder Ionenimplantation hergestellt. Anschließend wird eine dünne Oxidschicht 38 aufgebracht, die die Kontaktzone 36 beim Aufbringen der nächsten, dritten Sperrmaske 34 vor Verunreinigungen geschützt. Abhängig von den jeweiligen Prozeßparametern ist diese Schicht 38 nicht in jedem Falle erforderlich. Die dritte Sperrmaske 34 ist in Fig. 1G aufgebracht. Wie die erste und die zweite Sperrmaske hat diese dritte Sperrmaske 34 die Aufgabe, die Bereiche der Maskierungsschichten abzudecken, die nicht bis zur Epitaxiechicht 7 abgeätzt werden sollen. Im betrachteten Ausführungsbeispiel wird durch die dritte Sperrmaske 34 lediglich der Bereich des Fensters 22 nicht abgedeckt. Im Bereich dieses Fensters sollen Basis- und Emitterzone des Bipolartransistors verwirklicht werden. Unter Anwendung der bereits angegebenen Ätztechniken wird das Fenster 22' bis zur Oberfläche der Epitaxieschicht 7 geätzt. Anschließend wird eine $P^+$-dotierte Zone 40 in die Epitaxieschicht 7 eingebracht. Diese Zone bildet die Basiszone des Transistors.

In der Struktur gemäß Fig. 1H sind sämtliche erfindungsgemäßen Verfahrensschritte durchgeführt.

In der Struktur gemäß Fig. 1I ist auf konventionelle Weise in der Basiszone 40 eine Emitterzone 42 gebildet.

Das erfindungsgemäße Verfahren ist am Beispiel der Herstellung eines NPN—Transistors beschrieben, in gleicher Weise könnte natürlich ein PNP—Transistor erzeugt werden, wenn Substrat 2 und Epitaxieschicht 7 vom entgegengesetzten Leitungstyp gewählt werden. Das erfindungsgemäße verfahren läßt sich ganz allgemein bei der Herstellung verschiedenster integrierter Komponenten anwenden. Außerdem ist die angegebene Schrittfolge, wie sie durch die Fign. 1A bis 1I gekennzeichnet ist, nicht in jedem Falle einzuhalten. Beispielsweise kann die Zone 36 auch nach der Zone 40 gebildet werden.

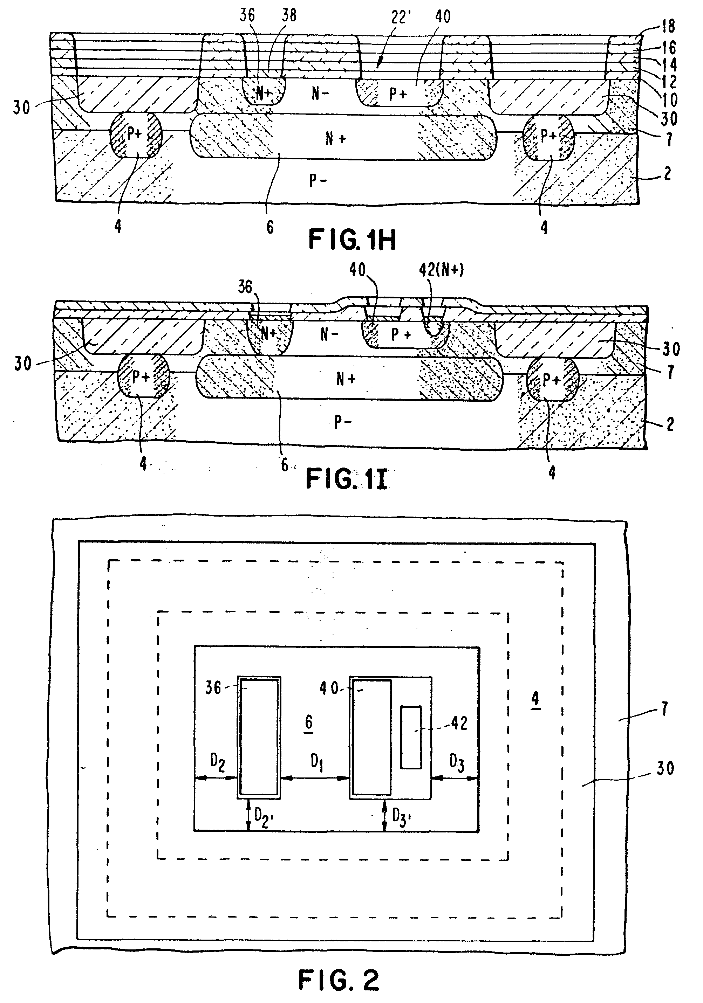

Die in Fig. 1I im Schnitt gezeigte Struktur ist in Fig. 2 in Draufsicht dargestellt. Die beim Herstellungsprozeß kritischen Abmessungen, die bei dem erfindungsgemäßen Verfahren automatisch ausgerichtet sind, sind mit D1, D2, D2', D3 und D3' bezeichnet. Die Abmessungen D2, D2' und D3, D3' können gleich oder auch unterschiedliche Werte aufweisen, abhängig von den Auslegungsparametern. Durch Ausnutzung der erfindungsgemäßen automatischen Ausrichtung kann die Entfernung D1 zwischen der Kontaktzone 36 und der Basiszone 40 typisch zwischen 1 bis 4 $\mu$m gewählt werden. Die Entfernung D2 (oder D2') zwischen der Kontaktzone 36 und der Isolationszone 30 liegt zwischen 1 bis 2,5 $\mu$m. Die Entfernung D3 (oder D3') zwischen der Basiszone 40 und der Isolationszone 30 beträgt beispielsweise 1 bis 2, 5$\mu$m. Für den Fachmann ist es offensichtlich, daß in der bekannten, üblichen Technik derartig günstige Werte nicht zu erreichen sind. Es lassen sich jedoch noch noch kleinere Abstände realisieren. Die Werte für D3/D3' ergeben sich daraus, daß zwischen der Basiszone 40 und der Isolationszone 30 ein gewisser Abstand erwünscht ist. Es sind jedoch auch Strukturen von Bedeutung, bei denen die Basiszone direkt an die dielektrische Isolationszone anschließt. Auch in diesem Fall ist das erfindungsgemäße verfahren anwendbar, wobei die Ausrichtung der Basiszone 40 im bezug auf die isolationszone 30 völlig unkritisch Beim erfindungsgemäßen Verfahren kann insbesondere die Elektronenstrahl-Lithographie oder das Projektionsdrucken angewandt werden, wobei die oben angegebenen Entfernungen bis auf 0,6 $\mu$m reduzierbar sind. Ausschlaggebend ist, daß mit Hilfe des erfindungsgemäßen Verfahrens integrierte Anordnungen mit extrem hoher Dichte verwirklichbar sind, da mit hoher Ausbeute extrem kleine Strukturen herstellbar sind.

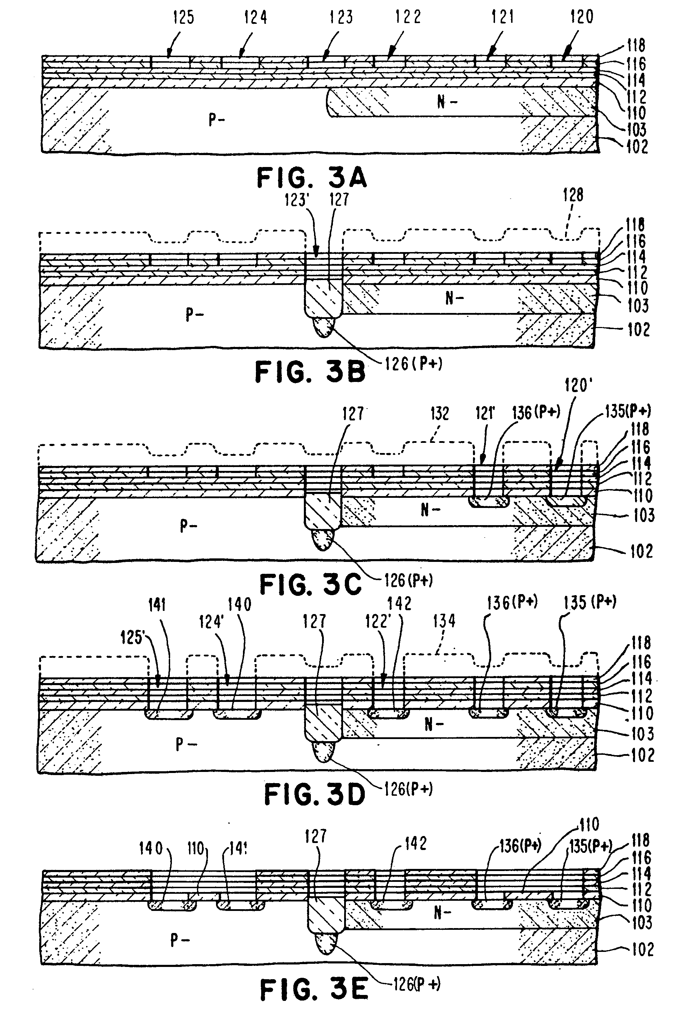

Anhand der Fign. 3A bis 3E ist das erfindungsgemäße Verfahren in Verbindung mit der Herstellung komplementärer Metall-Oxid-Halbleiter-Feldeffekttransistoren (CMOSFET'S) beschrieben. In das in Fig. 3A gezeigte $P^-$-dotierte Substrat 102 ist eine $N^-$-dotierte Zone 103 eingebracht. Auf die Oberfläche des Substrats sind fünf mit dem Bezugszeichen 110, 112, 114, 116 und 118 bezeichnete Schichten aufgebracht. Diese Schichten entsprechen exakt den Schichten 10, 12, 14, 16 und 18 in den Fign. 1A bis 1H. Das bedeutet also, daß die erste Zusatzschicht 110 aus Siliciumdioxide, die dritte Mas-

5

kierungsschicht 112 aus Siliciumoxynitrid, die zweite Maskierungsschicht 114 aus Siliciumdioxid, die erste Maskierungsschicht 116 aus Siliciumnitrid und die zweite Zusatzschicht 118 aus Siliciumdioxid besteht. Das Aufbringen der Schichten kann vorteilhafter Weise wieder unter Anwendung der bereits genannten Techniken erfolgen. Wie bekannt, wird die $N^-$-dotierte Zone 103 verwendet, um einen P-Kanal-FET herzustellen. Der benachbarte Bereich des $P^-$-dotierten Substrates 102 ist dann für einen N-Kanal-FET vorgesehen. In einem Halbleiterchip lassen sich tausende solcher Elemente bilden. Die Isolationszonen in Form von diffundierten Zonen oder von dielektrischen Zonen besorgen die gegenseitige Isolation der Feldeffekttransistoren.

In die zweite Zusatzschicht 118 und in die erste Maskierungsschicht 116 werden wiederum unter Verwendung einer Bemessungsmaske Fenster geätzt. Die Fenster sind mit den Bezugszeichen 120 bis 125 versehen. Die Bereiche in der Zone 103 unterhalb der Fenster 120 und 121 sind für die Source und Drain des P-Kanal-FETs eine $N^5$-dotierte Kontaktzone auf. Im Bereich unterhalb des Fensters 123 ist eine Isolationszone vorgesehen. Die Bereiche unterhalb der Fenster 124 und 125 nehmen Source und Drain des P-Kanal-FETs vorgesehen. Der Bereich unter dem Fenster 122 nimmt eine $N^+$-dotierte Kontaktzone auf. Im Bereich unterhalb des Fensters 123 ist eine Isolationszone vorgesehen. Die Bereiche unterhalb der Fenster 124 und 125 nehmen Source und Drain eines N-Kanal-FETs auf. Die zur Herstellung der Fenster 120 bis 125 verwendete Maske entspricht der Bemessungsmaske 19 in Fig. 1B. Auf eine erneute Darstellung wurde deshalb verzichtet.

Wie aus der Fig. 3B zu ersehen, wird das Fenster 123' nun bis zum Substrat 102 in einem Bereich geöffnet, in dem die Zone 103 endet. Dazu wird eine erste Sperrmaske 128 verwendet, die durch eine gestrichelte Linie angedeutet ist. Das Fenster 123' wird in derselben Weise hergestellt, wie es in Verbindung mit der Herstellung eines Bipolartransistors beschrieben ist. Die zweite Maskierungsschicht 114 aus Siliciumdioxid wird mit gepufferter Flußsäure, die erste Maskierungsschicht 112 aus Siliciumoxynitrid mit heißer Phosphorsäure und die erste Zusatzschicht 110 aus Siliciumdioxid wiederum mit gepufferter Flußsäure geätzt. Beim Ätzen der dritten Maskierungsschicht 112 wirkt die zweite Maskierungsschicht 114 als Maske. Beim Ätzen der ersten Zusatzschicht 110 wirkt die dritte Maskierungsschicht 112 als Maske.

Nach der Herstellung des Fenster 123' werden, wie in Fig. 3D dargestellt, Isolationszonen 126 und 127 erzeugt. Die Isolationszone 126 ist eine $P^+$-dotierte Zone, die unterhalb der dielektrischen Isolationszone 127 als Kanalsperrzone wirkt. Die dielektrische Isolationszone 127 kann wieder in der bereits in Verbindung mit der dielektrischen Isolationszone 30 beschriebenen Weise hergestellt werden. Die $P^+$-dotierte Isolationszone 126 kann durch Ionenimplantation oder Diffusion vor der Bildung der Zone 127 hergestellt werden. Derartige Zonen und die zur Herstellung angewandten Techniken sind dem Fachmann hinreichend bekannt. Selbstverständlich sind auch andere Isolationszonenanordnungen mit Hilfe des erfindungsgemäßen Verfahrens herstellbar.

Nach der Herstellung der Isolationszone 127 wird eine zweite Sperrmaske 132 aufgebracht, belichtet und entwickelt, so daß lediglich die Bereiche der Fenster 120 und 121 unbedeckt bleiben. Die Fenster 120' und 121' werden in gleicher Weise wie das Fenster 123' geöffnet. Anschließend werden die $P^+$-dotierten Zonen 135 und 136 durch Diffusion oder Ionenimplantation eingebracht. Diese Zonen bilden Source und Drain des P-Kanal-FETs (Fig. 3C).

Wie das Einbringen der Zonen 140, 141 und 142 (Fig. 3D) schließt den erfindungsgemäßen Verfahrensablauf ab. Diese Zonen werden mit Hilfe einer dritten Sperrmaske 134 eingebracht, die mit Ausnahme der Fenster 122, 124 und 125 die gesamte Oberfläche des Substrats abdeckt. Es werden dann die Fenster 122', 124' und 125' freigelegt und in ihrem Bereich die $N^+$-dotierten Zonen 142, 140 und 141 eingebracht. Die Zonen 140 und 141 bilden Source und Drain des N-Kanal-FETs. Die Zone 142 bildet eine Kontaktzone, über die eine geeignete Vorspannung an die $N^-$-dotierte Zone 103 anlegbar ist.

Die Gesamtanordnung wird schließlich dadurch vervollständigt, daß die Maskierungsschichten im Bereich der Kanalzonen der FETs entfernt und durch eine die Gateisolation bildende dünne Oxidschicht ersetzt werden. Schließlich werden die erforderlichen Kontakte und die Gateelektrode (nicht dargestellt) aufgebracht. In einer Abwandlung kann auch die erste Zusatzschicht 110 als.

## Patentansprüche

1. Verfahren zum Herstellen von integrierten Halbleiteranordnungen, bei dem auf einem Halbleiterkörper (7; 103) übereinanderliegend eine obere, erste Maskierungsschicht (16; 116) und eine unter Maskierungsschicht (14; 114) aufgebracht werden, bei dem in die erste Maskierungsschicht ein der Gesamtmenge von im Halbleiterkörper zu bildenden Zonenteilmengen entsprechendes Gesamtmaskenmuster (20, 21, 22; 120 bis 125) geätzt wird, wobei die untere Maskierungsschicht als Ätzstopp dient, bei dem aufeinanderfolgend die nicht der jeweils in den Halbleiterkörper einzubringenden Zonenteilmenge entsprechenden Öffnungen des Gesamtmaskenmusters in der oberen Maskierungsschicht mit einer entsprechenden Sperrmaske (28, 32, 34) abgedeckt, unter Verwendung der ersten Maskierungsschicht (16; 116) als Ätzmaske nacheinander die der jeweils im Halbleiterkörper zu bildenden Zonenteilmenge entsprechenden Öffnungen der Maskenmuster in die untere Maskierungsschicht (14, 12; 114, 112) geätzt und die Zonenteilmengen in den Halbleiterkörper eingebracht werden, dadurch gekennzeichnet, daß als untere Maskierungsschicht eine zweite (14; 114) und eine dritte Maskierungsschicht (12; 112) auf den Halbleiterkörper (7; 103) aufgebracht werden, daß als erste (16; 116), zweite (14; 114) und dritte Maskierungsschicht (12; 112) voneinander unabhängig ätzbare Schichten verwendet werden und daß mindestens in die zweite Maskierungsschicht (·14; 114) nacheinander einer ersten, zweiten und dritten Teilmenge der zu bildenden Zonenteilmengen entsprechende Maskenmuster geätzt und entsprechende Zonenteilmengen (30, 36, 40; 127, 135, 136, 140, 141, 142) in den Halbleiterkörper eingebracht werden.

2. Verfahren nach Anspruch 1, dadurch gekennzeichnet, daß die erste Maskierungsschicht (16; 116) aus siliciumnitrid, die zweite Maskierungsschicht (14; 114) aus Siliciumdioxid und die dritte Maskierungsschicht (12; 112) aus Siliciumoxynitrid besteht.

3. Verfahren nach Anspruch 2, dadurch gekennzeichnet, daß zum Ätzen der ersten (16; 116) und dritten Maskierungsschicht (12; 112) heiße Phosphorsäure und daß zum Ätzen der zweiten Maskierungsschicht (14; 114) gepufferte Flußsäure verwendet wird.

4. Verfahren nach Anspruch 1, dadurch gekennzeichnet, daß die erste Maskierungsschicht aus polykristallinem Silicium, die zweite Maskierungsschicht aus Siliciumdioxid und die dritte Maskierungsschicht aus Siliciumoxynitrid besteht.

5. Verfahren nach Anspruch 4, dadurch gekennzeichnet, daß zum Ätzen der ersten Maskierungsschicht Pyrocatechol, daß zum Ätzen der zweiten Maskierungsschicht gepufferte Flußsäure und daß zum Ätzen der dritten Maskierungsschicht heiße Phosphorsäure verwendet wird.

6. Verfahren nach den Ansprüchen 1, 2 oder 4, dadurch gekennzeichnet, daß das Ätzen der Maskierungsschichten durch reaktives Ionenätzen erfolgt.

7. Verfahren nach einem der Ansprüche 1 bis 6, dadurch gekennzeichnet, daß zwischen Halbleiterkörper (7; 103) und der dritten Maskierungsschicht (12; 112) zusätzlich eine erste Zusatzschicht (10; 110) aus Siliciumdioxid angeordnet wird, die jeweils vor dem Einbringen des Zonenmusters in den Halbleiterkörper entfernt oder einer Implantation ausgesetzt wird.

8. Verfahren nach einem der Ansprüche 1 bis 7, dadurch gekennzeichnet, daß auf die erste Maskierungsschicht (16; 116) eine zweite Zusatzschicht (18; 118) aus Siliciumdioxid aufgebracht wird, in die das Gesamtmaskenmuster geätzt wird und die anschließend als Ätzmaske für die erste Maskierungsschicht (16; 116) dient.

9. Verfahren nach Anspruch 7 oder 8, dadurch gekennzeichnet, daß die Dicken der zweiten Zusatzschicht (18; 118), der zweiten Maskierungsschicht (14; 114) und der ersten Zusatzschicht (10; 110) im Verhältnis 4:2:1 abgestuft sind.

10. Verfahren nach einem der Ansprüche 1 bis 9 dadurch gekennzeichnet, daß die erste Maskierungsschicht (16; 116) mindestens doppelt so dick wie die dritte Maskierungsschcht (12; 112) gewählt wird.

11. Verfahren nach einem der Ansprüche 1 bis 10, dadurch gekennzeichnet, daß die der ersten Teilmenge entsprechende Zonenteilmenge dielektrische Isolationszonen (30; 127) und daß die der zweiten und dritten Teilmenge entsprechende Zonenteilmenge dotierte Halbleiterzonen umfaßt.

12. Verfahren nach Anspruch 11, dadurch gekennzeichnet, daß die der zweiten Teilmenge entsprechende Zonenteilmenge Source- (135) und Drainzonen (136) eines FETs mit einem Kanal eines ersten Leitungstyps und die der dritten Teilmenge entsprechende Zonenteilmenge Source- (140) und Drainzonen (141) eines FETs mit einem Kanal eines zweiten Leitungstyps umfaßt.

## Revendications

1. Procédé pour fabriquer des arrangements semi-conducteurs intégrés, dans lequel on superpose sur un substrat semi-conducteur (7; 103) une première couche de masquage supérieure (16;.116) et une seconde couche de masquage inférieure (14; 114); dans lequel on décape dans la première couche de masquage une configuration de masquage (20, 21, 22; 120 à 125) correspondant à la totalité des régions partielles à former dans le substrat semi-conducteur, la couche de masquage inférieure servant de couche d'arrêt de décapage; dans lequel les ouvertures de la configuration de masquage dans la couche de masquage supérieure qui ne correspondent pas aux régions partielles à former dans le substrat semi-conducteur sont recouvertes d'un masque de blocage (28, 32, 34), en décapant à l'aide de la première couche de masquage (16; 116) utilisée comme masque de décapage successivement les ouvertures de la configuration de masquage correspondant aux régions partielles à former dans le corps semi-conducteur dans la couche de masquage inférieure (14, 12; 114, 112) et à former les régions partielles dans le corps semi-conducteur, caractérisé en ce que l'on dépose sur le substrat semi-conducteur (7; 103) comme couche de masquage inférieure des seconde (14, 114) et troisième (12; 112) couches de masquage, l'on utilise comme première (16; 116), seconde (14; 114) et troisième (12; 112) couches de masquage des couches pouvant être décapées sélectivement, et l'on décape au moins dans la seconde couche de masquage (14; 114) successivement une configuration de masquage correspondant aux premières, secondes et troisièmes régions partielles à former et l'on forme dans le substrat semi-conducteur les régions partielles correspondantes (30, 36, 40; 127, 135, 136, 140, 141, 142).

2. Procédé selon la revendication 1, caractérisé en ce que la première couche de masquage (16;

116) est du nitrure de silicium, la seconde couche de masquage (14; 114) du dioxyde de silicium et la troisième couche de masquage (12; 112) de l'oxynitrure de silicium.

3. Procédé selon la revendication 2, caractérisé en ce que l'on utilise de l'acide phosphorique chaud pour le décapage des première (16; 116) et troisième (12; 112) couches de masquage; et de l'acide fluorhydrique tamponné pour le décapage de la seconde couche de masquage (14; 114).

4. Procédé selon la revendication 1 caractérisé en ce que la première couche de masquage est composée de silicium polycristallin, la seconde couche de masquage est composée de dioxyde de silicium et la troisième couche de masquage d'oxynitrure de silicium.

5. Procédé selon la revendication 4, caractérisé en ce que l'on utilise de la pyrocatéchine pour le décapage de la première couche de masquage, de l'acide fluorhydrique tamponné pour le décapage de la seconde couche de masquage et de l'acide phosphorique chaud pour le décapage de la troisième couche de masquage.

6. Procédé selon la revendication 1, 2 ou 4, caractérisé en ce que les couches de masquage sont décapées à l'aide du procédé de décapage par ions réactifs.

7. Procédé selon l'une quelconque des revendications 1 à 6, caractérisé en ce que l'on dispose entre le substrat semi-conducteur (7; 103) et la troisième couche de masquage (12; 112) une première couche supplémentaire (10; 110) de dioxyde de silicium qui est enlevée ou soumise à un processus d'implantation avant la formation de la configuration de régions dans le substrat semi-conducteur

8. Procédé selon l'une quelconque des revendications 1 à 7, caractérisé en ce que l'on dépose sur la première couche de masquage (16; 116) une seconde couche supplémentaire (18; 118) de dioxyde de silicium dans laquelle on décape la configuration de masquage et qui est ensuite utilisée comme masque de décapage pour la première couche de masquage (16; 116).

9. Procédé selon la revendication 7 ou 8, caractérisé en ce que les épaisseurs de la seconde couche supplémentaire (18; 118), de la seconde couche de masquage (14; 114) et de la première couche supplémentaire (10; 110) sont dans un rapport de 4:2:1.

10. Procédé selon l'une quelconque des revendications 1 à 9, caractérisé en ce que la première couche de masquage (16; 116) a une épaisseur qui est au moins le double de celle de la troisième couche de masquage (12; 112).

11. Procédé selon l'une quelconque des revendications 1 à 10, caractérisé en ce que les régions partielles corresondant aux premières régions sont des régions d'isolement diélectrique (30; 127) et en ce que les régions partielles correspondant aux secondes et troisièmes régions comprennent des régions semi-conductrices dopées.

12. Procédé selon la revendication 11, caractérisé en ce que les régions partielles correspondant aux secondes régions comprennent des régions de source (135) et des régions de drain (136) d'un transistor à effet de champ ayant un canal du premier type de conductivité et en ce que les régions partielles correspondant aux troisièmes régions comprennent des régions de source (140) et des régions de drain (141) d'un transistor à effet de champ ayant un canal du second type de conductivité.

**Claims**

1. Method for manufacturing integrated semiconductor arrays, wherein an upper first masking layer (16; 116) and a lower second masking layer (14; 114) are superimposed atop a semiconductor substrate (7; 103), wherein a total masking pattern having openings (20, 21, 22; 120 to 125) corresponding to the total number of regions eventually to be formed in the semiconductor substrate is etched into the first masking layer with the second masking layer serving as an etch stop, wherein the openings of the total masking pattern in the upper masking layer not corresponding to a particular subset of regions to be introduced into the semiconductor substrate are covered by blocking mask (28, 32, 34), and, using the first masking layer (16; 116) as an etching mask, the openings of the masking pattern corresponding to the particular subset of regions to be formed in the semiconductor substrate are etched into the lower masking layer (14; 114), the subset of regions thereafter being introduced into the semiconductor substrate, characterized in that: the lower masking layer comprises second and third masking layers (14, 114; 12, 112) desposited atop the semiconductor substrate (7; 103), the first (16; 116), second (14; 114) and third (12; 112) masking layers are selectively etchable with respect to each other, masking patterns corresponding to first, second and third subsets of the total number of regions to be formed are successively etched at least into the second masking layer (14; 114), and corresponding subsets of regions (30, 36, 40; 127, 135, 136, 140, 141, 142) are introduced into the semiconductor substrate.

2. Method as in claim 1, characterized in that the first masking layer (16; 116) consists of silicon nitride, the second masking layer (14; 114) consists of silicon dioxide, and the third masking layer (12; 112) consists of silicon oxynitride.

3. Method as in claim 2, characterized in that etching of the first (16; 116) and third masking layers (12; 112) is accomplished in hot phosphoric acid, and etching of the second masking layer (14; 114) is accomplished in buffered hydrofluoric acid.

4. Method as in claim 1, characterized in that the first masking layer consists of polycrystalline silicon, the second masking layer consists of silicon dioxide and the third masking layer consists of silicon oxynitride.

5. Method as in claim 4, characterized in that pyrocatechol is used to etch the first masking layer, buffered hydrofluoric acid is used to etch the second masking layer and hot phosphoric acid is used to etch the third masking layer.

6. Method as in claims 1, 2 or 4, characterized in that the etching steps are accomplished by reactive ion etching.

7. Method as in one of the claims 1 to 6, characterized in that a first additional layer (10; 110) consisting of silicon dioxide is formed between the semiconductor substrate (7; 103) and the third masking layer (12; 112) and removed or exposed to implantation prior to the introduction of the individual region patterns into the semiconductor substrate.

8. Method as in one of the claims 1 to 7, characterized in that a second additional layer (18; 118) consisting of silicon dioxide is formed atop the first masking layer (16; 116), in which layer the total masking pattern is etched, and which layer subsequently serves as an etching mask for said first masking layer (16; 116).

9. Method as in claims 7 or 8, characterized in that the thicknesses of the second additional layer (18; 118), the second masking layer (14; 114) and the first additional layer (10; 110) are staggered in the ratio 4:2:1.

10. Method as in one of the claims 1 to 9, characterized in that the first masking layer (16; 116) is selected to be at least twice as thick as the third masking layer (12; 112).

11. Method as in one of the claims 1 to 10, characterized in that the region subset corresponding to the first subset comprises dielectric isolation regions (30; 127) and the region subsets corresponding to the second and third subsets comprise doped semiconductor regions.

12. Method as in claim 11, characterized in that the region subset corresponding to the second subset comprises source regions (135) and drain regions (136) of an FET with a first conductor type channel, and the region subset corresponding to the third subset comprises source regions (140) and drain regions (141) of an FET with a second conductor type channel.

FIG. 1A

FIG. 1B

FIG. 1C

FIG. 1D

FIG. 1E

FIG. 1F

FIG. 1G

2

0 000 327

FIG. 1H

FIG. 1I

FIG. 2

3

FIG. 3A

FIG. 3B

FIG. 3C

FIG. 3D

FIG. 3E